# EUROPEAN PATENT APPLICATION

(11) **EP 4 112 691 A1**
(43) Date of publication of application: **04.01.2023**
(21) Application number: 21761340.5
(22) Date of filing: 24.02.2021
(51) Int. Cl.: C08L 61/14, C08L 63/00, C08K 3/01, H05K 1/05

(54) **THERMALLY CURABLE RESIN COMPOSITION, RESIN SHEET, AND METAL-BASED SUBSTRATE**

(30) Priority: 27.02.2020 JP 2020031440
(71) Applicant: Sumitomo Bakelite Co., Ltd., Shinagawa-ku Tokyo 140-0002 (JP)
(72) Inventor: ENDO, Tadasuke, Tokyo 140-0002 (JP); KASHINO, Tomomasa, Tokyo 140-0002 (JP)
(74) Representative: Ter Meer Steinmeister & Partner
(86) International application number: PCT/JP2021/006950
(87) International publication number: WO 2021/172387

(57) **Abstract**

The thermosetting resin composition of the present invention includes an epoxy resin (A), a curing agent (B), and thermally conductive particles (C), in which the epoxy resin (A) includes a mesogen skeleton and has a softening point of 60°C or lower, and a thermal conductivity λ₂₀₀ of a cured product of the thermosetting resin composition at 200°C is 12.0 W/(m·K) or higher.

## Description

### TECHNICAL FIELD

The present invention relates to a thermosetting resin composition, a resin sheet formed of the composition, and a metal base substrate including the resin sheet.

### BACKGROUND ART

There is a demand for a heat dissipation property with respect to insulating materials forming electrical and electronic devices and the like. Various developments have been made regarding the heat dissipation property of insulating materials.

As this type of technology, for example, the technology described in Patent Document 1 is known. Patent Document 1 describes a thermosetting resin composition using bisphenol A-type epoxy resin as a thermosetting resin and using scaly or spherical boron nitride particles as thermally conductive particles.

### RELATED DOCUMENT

### PATENT DOCUMENT

[Patent Document 1] Japanese Unexamined Patent Application, First Publication No. 2015-193504

### SUMMARY OF THE INVENTION

### TECHNICAL PROBLEM

However, in the technology of the related art described in Patent Document 1, the resin sheet obtained from the thermosetting resin composition has low flexibility, and, when processing a circuit or the like in a metal base substrate provided with this resin sheet as an insulating layer, cracks or the like may appear in the resin sheet and there is room for improvement in the processing process resistance.

It is conceivable to use a liquid epoxy resin or the like to improve the processing process resistance by imparting flexibility to the resin sheet; however, in a case of using a liquid resin, it was not possible to achieve high thermal conductivity. That is, there was a trade-off relationship between improving the processing process resistance of the resin sheet and achieving high thermal conductivity.

### SOLUTION TO PROBLEM

The present inventors found that it is possible to solve the problem described above in specific combinations and completed the invention provided below.

According to the present invention, there is provided a thermosetting resin composition including an epoxy resin (A), a curing agent (B), and thermally conductive particles (C), in which the epoxy resin (A) includes a mesogen skeleton and has a softening point of 60°C or lower, and a thermal conductivity λ₂₀₀ of a cured product of the thermosetting resin composition at 200°C is 12.0 W/(m·K) or higher.

According to the present invention, there is provided a resin sheet including the thermosetting resin composition.

According to the present invention, there is provided a metal base substrate including in the following order: a metal substrate, an insulating layer comprised of the resin sheet, and a metal layer.

In the present invention, processing process resistance means, for example, in the case of forming a circuit on a resin sheet, suppressing cracking or the like of the resin sheet generated by stress during processing and formation.

### ADVANTAGEOUS EFFECTS OF INVENTION

According to the present invention, it is possible to provide a thermosetting resin composition from which a resin sheet having excellent processing process resistance and high thermal conductivity is obtained, a resin sheet including the composition, and a metal base substrate including the resin sheet. In other words, the resin sheet obtained from the thermosetting resin composition of the present invention has an excellent balance of these properties.

### BRIEF DESCRIPTION OF THE DRAWINGS

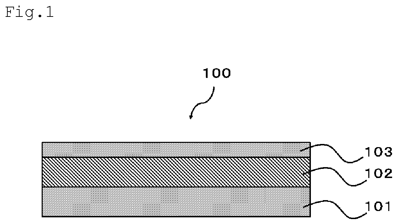

Fig. 1 is a schematic cross-sectional view showing a configuration of a metal base substrate according to the present embodiment.

### DESCRIPTION OF EMBODIMENTS

A description will be given below of embodiments of the present invention using a drawing. In the drawing, similar components are marked with similar symbols and description thereof will not be repeated as appropriate. In addition, "A to B" represents "A or more" and "B or less" unless otherwise stated.

The thermosetting resin composition of the present embodiment includes an epoxy resin (A), a curing agent (B), and thermally conductive particles (C), in which the epoxy resin (A) includes a mesogen skeleton and has a softening point of 60°C or lower. A thermal conductivity λ₂₀₀ of a cured product of the thermosetting resin composition at 200°C is 12.0 W/(m·K) or higher.

### [Epoxy Resin (A)]

The epoxy resin (A) of the present embodiment includes a mesogen skeleton and has a softening point of 60°C or lower, preferably 55°C or lower, and more preferably 52°C or lower. By the softening point of the epoxy resin (A) being in the above range, it is possible to impart flexibility to the obtained resin sheet to improve the processing process resistance. Furthermore, including a mesogen skeleton makes it possible to improve the thermal conductivity (heat dissipation property) during curing.

It is considered that a higher-order structure (liquid crystal phase or crystalline phase) is formed by the mesogen skeleton when the epoxy resin including the mesogen skeleton is cured. It is considered that the thermal conductivity (heat dissipation property) is further improved by the transmission of heat through the higher-order structure. It is possible to investigate the presence of higher-order structures in the cured product by observation with a polarizing microscope.

Examples of the mesogen skeleton may include any skeleton which facilitates the expression of liquid crystallinity and crystallinity through the action of intermolecular interactions. The mesogen skeleton preferably includes a conjugated structure. Specific examples of mesogen skeletons include biphenyl skeletons, phenylbenzoate skeletons, azobenzene skeletons, stilbene skeletons, naphthalene skeletons, anthracene skeletons, phenanthrene skeletons, and the like.

The epoxy resin (A) preferably includes a biphenyl skeleton or a naphthalene skeleton as the mesogen skeleton.

For example, with a biphenyl skeleton (-C₆H₄-C₆H₄-), there is a possibility that, at high temperatures, thermal motion may "rotate" the carbon-carbon single bond portion at the center of the left-hand structure and decrease the liquid crystallinity. Similarly, with a phenylbenzoate skeleton (-C₆H₄-COO-C₆H₄-), there is a possibility that the ester bond may rotate at high temperatures . However, for condensed polycyclic aromatic hydrocarbon skeletons such as a naphthalene skeleton, in principle, there is no decrease in liquid crystallinity due to such rotation. In other words, including a condensed polycyclic aromatic hydrocarbon skeleton in the epoxy resin makes it easier to design λ₂₀₀ to be 12.0 W/(m·K) or higher and thus to further improve the heat dissipation property in high temperature environments.

In addition, using a naphthalene skeleton in particular as a polycyclic aromatic hydrocarbon skeleton also makes it possible to suppress the epoxy resin from becoming excessively rigid while obtaining the above advantages. This is because the naphthalene skeleton is comparatively small as a mesogen skeleton. The fact that the epoxy resin is not excessively rigid is preferable in terms of the suppression of cracks and the like due to easy alleviation of stress during the curing of the thermosetting resin composition of the present embodiment.

It is possible to use the epoxy resin (A) without particular limitation as long as a mesogen skeleton is included and the softening point is 60°C or lower. Examples thereof include naphthalene-type epoxy resins and biphenol-type epoxy resins and it is possible to use at least one type thereof.

The epoxy resins (A) preferably include a bifunctional or higher epoxy resin. In other words, two or more epoxy groups are preferably included in one molecule of the epoxy resin. The number of functional groups of the epoxy resin is preferably 2 to 6 and more preferably 2 to 4.

From the viewpoint of the effect of the present invention, the epoxy resin in the present embodiment preferably includes one or two or more selected from the compounds represented by the following formula and the resins given as examples.

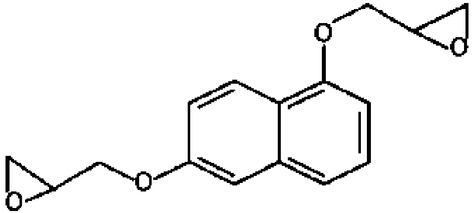

Examples of the epoxy resins (A) include HP-4032D manufactured by DIC Corporation (bifunctional naphthalene-type liquid epoxy resin), HP-6000L (multifunctional solid epoxy resin containing a naphthalene skeleton), NC-3000/NC-3000L manufactured by Nippon Kayaku Co., Ltd. (biphenyl aralkyl-type epoxy resin) and the like.

The epoxy resin (A) is, for example, 5% by mass to 40% by mass, preferably 7% by mass to 35 % by mass, and more preferably 10% by mass to 30 % by mass, with respect to the resin component (100 % by mass) of the thermosetting resin composition not including the thermally conductive particles (C). Due to this, it is possible to ensure sufficient processing process resistance and, in addition, to easily achieve a λ₂₀₀ of 12.0 W/(m·K) or higher and to obtain a resin sheet with excellent high thermal conductivity and insulation properties.

In the present embodiment, it is possible to include other epoxy resins than the epoxy resin (A). The other epoxy resin may have a softening point which exceeds 60°C, but preferably includes a mesogen skeleton from the viewpoint of high thermal conductivity and insulation properties.

It is possible for the other epoxy resins to include, for example, one or two or more selected from compounds represented by the following formula.

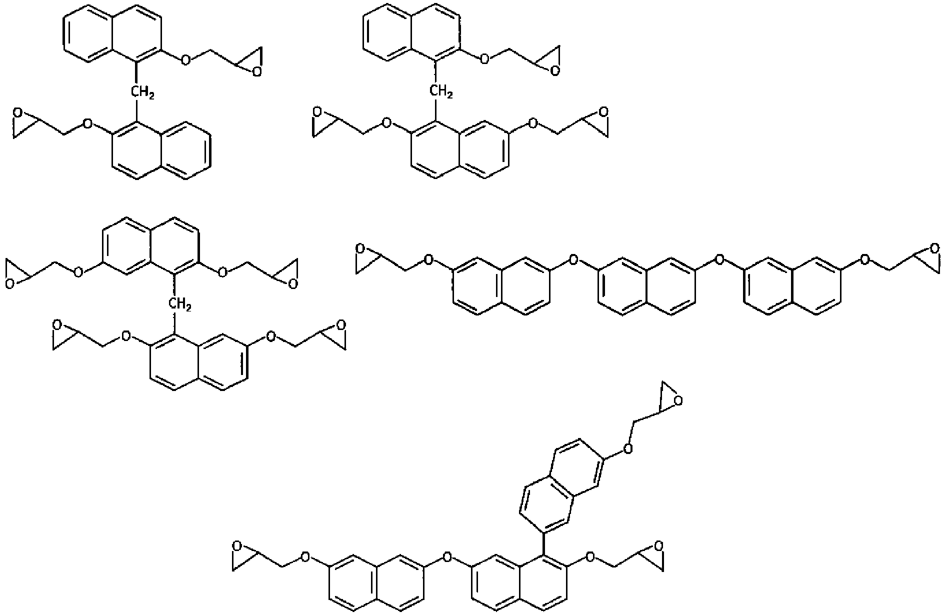

### [Curing Agent (B)]

The thermosetting resin composition of the present embodiment includes a curing agent (B). As the curing agent (B), it is possible to use phenol resin, cyanate resin, benzoxazine resin, active ester resin, and the like and it is preferable for cyanate resin to be included. With respect to the cured product of the thermosetting resin composition, it is possible to achieve low linear expansion and improvement of the modulus of elasticity and rigidity. In addition, it is also possible to contribute to improving the heat resistance and moisture resistance of the obtained metal base substrate.

In addition, one type of cyanate resin may be used alone or two or more types may be used in combination and one type or two or more types and prepolymers thereof may be used in combination.

As the cyanate resins, for example, it is possible to include one or two or more selected from novolac-type cyanate resins; bisphenol-type cyanate resins such as bisphenol A-type cyanate resin, bisphenol E-type cyanate resin and tetramethyl bisphenol F-type cyanate resin; naphthol aralkyl-type cyanate resins obtained by the reaction of naphthol aralkyl-type phenolic resins with cyanogen halide; dicyclopentadiene-type cyanate resins; and phenol-aralkyl-type cyanate resins containing a biphenylene skeleton. Among the above, from the viewpoint of the effects of the present invention, it is more preferable to include at least one of a novolac-type cyanate resin and a naphthol aralkyl-type cyanate resin and it is particularly preferable to include a novolac-type cyanate resin.

As a novolac-type cyanate resin, for example, it is possible to use those shown by General Formula (I).

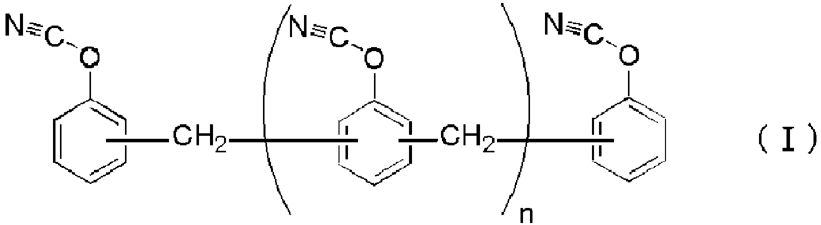

The average repeating unit n of the novolac-type cyanate resin shown by General Formula (I) is an arbitrary integer. The average repeating unit n is not particularly limited, but one or more is preferable and two or more is more preferable. When the average repeating unit n is the lower limit value described above or more, it is possible to improve the heat resistance of the novolac-type cyanate resin and to further suppress the desorption and volatilization of low volume substances during heating. In addition, the average repeating unit n is not particularly limited, but 10 or less is preferable and 7 or less is more preferable. When n is the upper limit value described above or less, it is possible to suppress the melt viscosity from becoming high and to improve the moldability of the resin sheet.

In addition, naphthol aralkyl-type cyanate resins represented by General Formula (II) may also be suitably used as cyanate resins. The naphthol aralkyl-type cyanate resin represented by General Formula (II) is, for example, obtained by condensing a naphthol aralkyl-type phenolic resin obtained by the reaction between naphthols such as α-naphthol or β-naphthol and p-xylylene glycol, α,α'-dimethoxy-p-xylene, 1,4-di(2-hydroxy-2-(-propyl)benzene or the like, and cyanogen halide. The repeating unit n of General Formula (II) is preferably an integer of 10 or less. When the repeating unit n is 10 or less, it is possible to obtain a more uniform resin sheet. In addition, intramolecular polymerization is less likely to occur during synthesis and there is a tendency for it to be possible to improve the separation property during water washing and prevent a decrease in yield.

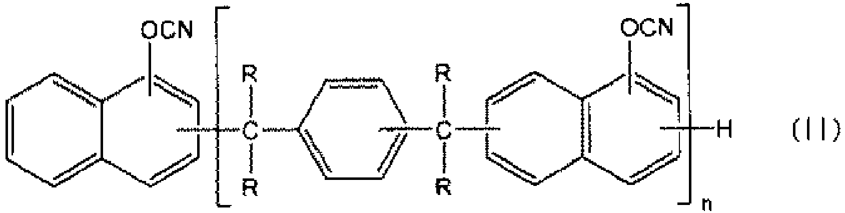

In General Formula (II), R independently indicates a hydrogen atom or a methyl group, and n indicates an integer of 1 or more and 10 or less.

The content of the curing agent (B) is, for example, 10% by mass to 70% by mass and preferably 20% by mass to 60% by mass, with respect to the resin component (100% by mass) of the thermosetting resin composition not including the thermally conductive particles (C). Due to this, it is possible to achieve more effective low linear expansion and a higher modulus of elasticity of the cured product of the thermosetting resin composition. It is possible to achieve a balance in the properties of the thermosetting resin composition.

### [Thermally Conductive Particles (C)]

The thermosetting resin composition of the present embodiment includes the thermally conductive particles (C).

It is possible for the thermally conductive particles (C) to include, for example, highly thermally conductive inorganic particles having a thermal conductivity of 20 W/m·K or higher. It is possible for the highly thermally conductive inorganic particles to include, for example, at least one or more selected from alumina, aluminum nitride, boron nitride, silicon nitride, silicon carbide, and magnesium oxide. The above may be used alone or two or more may be used in a combination.

It is possible for the boron nitride to include monodispersed particles or aggregated particles of scaly boron nitride or mixtures thereof. The scaly boron nitride may be granulated into a granulated shape. It is possible to further increase the thermal conductivity by using aggregated particles of scaly boron nitride. The aggregated particles may be sintered particles or non-sintered particles.

The content of the thermally conductive particles (C) is 100% by mass to 400% by mass, preferably 150% by mass to 350% by mass and more preferably 200% by mass to 320% by mass with respect to the resin component (100% by mass) of the thermosetting resin composition. It is possible to improve the thermal conductivity by setting the content to the above lower limit value or higher. By setting the content to the above upper limit value or lower, it is possible to suppress a decrease in processability (productivity). That is, with the range described above, there is an excellent balance between thermal conductivity and processability.

### [Phenoxy Resin (D)]

It is possible for the thermosetting resin composition of the present embodiment to include a phenoxy resin (D) as necessary. Including the phenoxy resin (D) makes it possible to further improve the processing process resistance of the resin sheet.

Examples of the phenoxy resins (D) include phenoxy resins having a bisphenol skeleton phenoxy resins having a naphthalene skeleton, phenoxy resins having an anthracene skeleton, phenoxy resins having a biphenyl skeleton, and the like. In addition, it is also possible to use phenoxy resins with a structure having a plurality of types of these skeletons.

From the viewpoint of the effect of the present invention, the content of the phenoxy resin (D) is, for example, 0.5% by mass to 10% by mass and preferably 1% by mass to 10% by mass, with respect to the resin component (100% by mass) of the thermosetting resin composition not including the thermally conductive particles (C).

### [Curing Accelerator (E)]

It is possible for the thermosetting resin composition of the present embodiment to include a curing accelerator (E) as necessary.

The type and blending amount of the curing accelerator (E) are not particularly limited, but it is possible to appropriately select the curing accelerator (E) from the viewpoints of reaction rate, reaction temperature, storability, and the like.

Examples of curing accelerators (E) include imidazoles, organophosphorous compounds, tertiary amines, phenolic compounds, organic acids, and the like. The above may be used alone or may be used in a combination of two or more. Among the above, it is preferable to use nitrogen atom-containing compounds such as imidazoles from the viewpoint of increasing heat resistance.

Examples of the imidazoles include 2-methylimidazole, 2-ethyl-4-methylimidazole, 2-phenyl-4 -methylimidazole, 2,4-diethylimidazole, 2-phenyl-4-methyl-5-hydroxyimidazole, 2-phenyl-4,5-dihydroxymethylimidazole, 1-cyanoethyl-2-phenylimidazole, 1-cyanoethyl-2-phenylimidazolium trimellitate, and the like.

Examples of the tertiary amines include triethylamine, tributylamine, 1,4-diazabicyclo[2.2.2]octane, 1,8-diazabicyclo(5,4,0)undecen-7, and the like.

Examples of the phenolic compounds include phenol, bisphenol A, nonylphenol, 2,2-bis (3-methyl-4-hydroxyphenyl) propane, and the like.

Examples of the organic acids include acetic acid, benzoic acid, salicylic acid, p-toluenesulphonic acid, and the like.

The content of the curing accelerator (E) is approximately 0.01% by mass to 10% by mass with respect to the resin component (100% by mass) of the thermosetting resin composition not including the thermally conductive particles (C).

It is possible for the thermosetting resin composition of the present embodiment to include other components other than the components described above. Examples of these other components include antioxidants and levelling agents.

An example of the method for manufacturing a thermosetting resin composition of the present embodiment is the following method.

It is possible to prepare a resin varnish (thermosetting resin composition in varnish form) by dissolving, mixing, and stirring each of the components described above in a solvent. For this mixing, it is possible to use various mixing machines, such as ultrasonic dispersion systems, high-pressure impact dispersion systems, high-speed rotary dispersion systems, bead mill systems, high-speed shear dispersion systems, and rotating and revolving dispersion systems.

The solvents described above are not particularly limited, but examples thereof include acetone, methyl isobutyl ketone, toluene, ethyl acetate, cyclohexane, heptane, cyclohexane, cyclohexanone, tetrahydrofuran, dimethylformamide, dimethylacetamide, dimethylsulphoxide, ethylene glycol, cellsorb-based solvents, carbitol-based solvents, anisole, N-methylpyrrolidone, and the like.

### [Resin Sheet]

The resin sheet of the present embodiment is formed by curing the thermosetting resin composition described above. The specific form of the resin sheet is provided with a carrier base material and a resin layer comprised of the thermosetting resin composition of the present embodiment provided on the carrier base material.

It is possible to obtain the resin sheet described above, for example, by performing a solvent removal process with respect to the coating film (resin layer) obtained by coating the varnish-like thermosetting resin composition onto the carrier base material. It is possible for the solvent content in the resin sheet to be 10% by mass or less with respect to the entire thermosetting resin composition. For example, it is possible to perform the solvent removal process under conditions of 80°C to 200°C for 1 minute to 30 minutes.

In addition, in the present embodiment, for example, it is possible to use polymer films, metal foils, and the like as the carrier base material described above. The polymer film is not particularly limited, but examples thereof include polyolefins such as polyethylene and polypropylene, polyesters such as polyethylene terephthalate and polybutylene terephthalate, polycarbonates, release papers such as silicone sheets, thermoplastic resin sheets having heat resistance such as fluorine-based resins and polyimide resins, and the like. The metal foils are not particularly limited, but examples thereof include copper and/or copper-based alloys, aluminum and/or aluminum-based alloys, iron and/or iron-based alloys, silver and/or silver-based alloys, gold and gold-based alloys, zinc and zinc-based alloys, nickel and nickel-based alloys, tin and tin-based alloys, and the like.

The resin substrate of the present embodiment is provided with an insulating layer comprised of a cured product of the thermosetting resin composition described above. It is possible to use this resin substrate as a material for printed substrates for mounting electronic components such as LEDs and power modules.

### (Metal Base Substrate)

A description will be given of a metal base substrate 100 of the present embodiment based on Fig. 1.

Fig. 1 is a schematic cross-sectional view showing an example of a configuration of the metal base substrate 100.

As shown in Fig. 1, it is possible for the metal base substrate 100 described above to be provided with a metal substrate 101, an insulating layer 102 provided on the metal substrate 101, and a metal layer 103 provided on the insulating layer 102. It is possible for this insulating layer 102 to be formed of one type selected from the group consisting of a resin layer comprised of a thermosetting resin composition described above, and a cured product and a laminate of the thermosetting resin composition. Each of these resin layers and laminates may be formed of a thermosetting resin composition in a B-stage state before circuit processing of the metal layer 103 and may be a cured body which is cured and processed therefrom after circuit processing.

The metal layer 103 is provided on the insulating layer 102 and is subjected to circuit processing. Examples of this metal forming the metal layer 103 include one or two or more types of metal selected from copper, copper alloy, aluminum, aluminum alloy, nickel, iron, tin, and the like. Among the above, the metal layer 103 is preferably a copper layer or an aluminum layer and particularly preferably a copper layer. Using copper or aluminum makes it possible to make the circuit processability of the metal layer 103 good. As the metal layer 103, a metal foil available in plate form may be used or a metal foil available in roll form may be used.

The lower limit value of the thickness of the metal layer 103 is, for example, 0.01 mm or more, preferably 0.035 mm or more, which is applicable to applications that require a high current.

In addition, the upper limit value of the thickness of the metal layer 103 is, for example, 10.0 mm or less and preferably 5 mm or less. When the thickness is these values or less, it is possible to improve the circuit processability and also to make the substrate as a whole thinner.

The metal substrate 101 has the role of dissipating the heat accumulated in the metal base substrate 100. The metal substrate 101 is not particularly limited beyond being a metal substrate with a heat dissipation property, for example, a copper substrate, a copper alloy substrate, an aluminum substrate, or an aluminum alloy substrate, with a copper substrate or an aluminum substrate being preferable and a copper substrate being more preferable. By using a copper substrate or aluminum substrate, it is possible to make the heat dissipation property of the metal substrate 101 good.

It is possible to appropriately set the thickness of the metal substrate 101 as long as the purpose of the present invention is not impaired.

The upper limit value of the thickness of the metal substrate 101 is, for example, 20.0 mm or less and preferably 5.0 mm or less. It is possible to improve the processability of the metal base substrate 100 in outline processing, cut-out processing, and the like at this value or less.

In addition, the lower limit value of the thickness of the metal substrate 101 is, for example, 0.01 mm or more and preferably 0.6 mm or more. By using the metal substrate 101 at this value or more, it is possible to improve the heat dissipation property of the metal base substrate 100 as a whole.

In the present embodiment, it is possible to use the metal base substrate 100 for various substrate applications, but use is possible as a printed substrate using LEDs and power modules since the thermal conductivity and heat resistance are excellent.

It is possible for the metal base substrate 100 to have the metal layer 103 which is circuit processed by etching into a pattern, or the like. In this metal base substrate 100, an unshown solder resist may be formed on the outermost layer and the electrode portions for connection may be exposed such that it is possible to mount electronic components thereon by exposure and development.

A description was given of embodiments of the present invention; however, these are examples of the present invention and it is possible to adopt various configurations other than those described above as long as the effects of the present invention are not impaired.

### [Examples]

A more detailed description will be given below of the present invention using Examples, but the present invention is not limited thereto.

### <Manufacturing of Thermosetting Resin Composition (Varnish-Like)>

A varnish-like thermosetting resin composition was obtained by stirring each component and solvent according to the blending ratios described in Table 1. In Table 1, the content of thermally conductive particles is % by weight with respect to the resin component of the thermosetting resin composition not including a thermally conductive filler.

The details of each component in Table 1 are as follows. The unit for the amount of each component in Table 1 is parts by mass.

### (Epoxy Resin (A))

- Epoxy resin 1: Bifunctional naphthalene-type epoxy resin (with mesogen structure, manufactured by DIC Corporation, HP-4032D, liquid at 25°C room temperature (softening point of 25°C or lower))
- Epoxy resin 2: Biphenyl aralkyl-type epoxy resin (with mesogen structure, manufactured by Nippon Kayaku Co., Ltd., NC-3000L, softening point 51°C)

### (Other Epoxy Resins)

- Epoxy resin 3: Bisphenol F-type epoxy resin (without mesogen structure, manufactured by DIC Corporation, EPICLON 830S, liquid at 25°C room temperature (softening point of 25°C or lower))
- Epoxy resin 4: Tetrafunctional naphthalene-type epoxy resin (with mesogen structure, manufactured by DIC Corporation, HP-4710, softening point 96°C)

### (Curing Agent (B))

- Curing agent 1: Novolac-type cyanate resin (without mesogen structure, manufactured by Lonza Japan, PT-30)

### (Thermally Conductive Particles (C))

- Thermally conductive particles 1: Aggregated boron nitride (manufactured by Mizushima Ferroalloy Co., Ltd., HP40)

### (Phenoxy Resin (D))

- Phenoxy resin 1: Bisphenol A-type phenoxy resin (manufactured by NIPPON STEEL Chemical & Material Co., Ltd., YP-55)

### (Curing Catalyst)

- Curing catalyst 1: Novolac-type phenolic compound (manufactured by Meiwa Plastic Industries, Ltd., MEH-8000H, liquid at 25°C room temperature)

### <Preparation of Samples for Measurement/Evaluation (Cured Products for Measurement)>

A varnish-like resin composition (P) was coated on a PET film and heat-treated at 100°C for 30 minutes to produce a thermally conductive sheet in B-stage form (a semi-cured state) with a film thickness of 200 µm (0.2 mm). The above was then peeled off from the PET film and heat-treated at 200°C for 90 minutes to obtain a thermally conductive sheet cured product.

This thermally conductive sheet cured product is also referred to as the "cured product for measurement" below.

### <Measurement of Characteristics of Cured Product of Thermosetting Resin Composition>

### (Thermal conductivity λ₂₀₀ at 200°C)

The thermal conductivity is determined by the formula α × Cp × Sp (α is the thermal diffusion coefficient, Cp is the specific heat, and Sp is density) . Thus, the thermal conductivity was determined by measuring α, Cp, and Sp respectively. Specifically, the above was carried out as follows.

- Measurement of Thermal Diffusion Coefficient α at 200°C

The cured product for measurement was cut out to a thickness of approximately 0.2 mm and a size of 10 mm × 10 mm. This was set in the apparatus "LFA447 NanoFlash" manufactured by NETZSCH and held at 200°C in air. Then, the thermal diffusion coefficient α at 200°C was measured by the laser flash method.

- Measurement of Specific Heat Cp at 200°C

The specific heat (Cp) at 200°C of the cured product for measurement was measured by the DSC method in accordance with JIS K 7123 (specific heat capacity measurement method for plastics).
- Measurement of Density Sp

Measurement of the density (Sp) was performed in accordance with JIS K 6911 (general test method for thermosetting plastics) . For the test piece, the cured product for measurement was cut out to 2 cm length × 2 cm width × 0.2 mm thickness.

The density Sp was measured at 23°C. Strictly speaking, in order to determine λ₂₀₀, it is necessary to determine the density Sp at 200°C; however, due to the difficulty of measurement and the like, the change in density Sp between 23°C and 200°C was ignored.
- Calculation of Thermal Conductivity λ₂₀₀ at 200°C

The thermal conductivity at 200°C, λ₂₀₀, was calculated by multiplying α, Cp, and Sp determined as described above.

### (Processing Process Resistance of Resin Sheet)

The B-stage form thermally conductive sheet was peeled from PET and the external appearance of the resin sheet after heat treatment at 200°C for 90 minutes was evaluated according to the following criteria.

### (Criteria)

∘: There are no cracks or chips in the resin sheet.
×: There are cracks or chips in the resin sheet.

**Table 1**

| | | Softening point | Mesogen skeleton | Unit | Example 1 | Example 2 | Comparative Example 1 | Comparative Example 2 |
|---|---|---|---|---|---|---|---|---|
| (A) Epoxy resin | Epoxy resin 1 | Liquid at room temperature | Yes (naphthalene) | Parts by mass | 20 | | | |
| | Epoxy resin 2 | 51°C | Yes (biphenyl) | | | 20 | | |
| Other epoxy resin not corresponding to (A) | Epoxy resin 3 | Liquid at room temperature | No | | | | 20 | |
| | Epoxy resin 4 | 96°C | Yes (naphthalene) | | 25 | 25 | 25 | 45 |
| (B) Curing agent | Curing agent 1 | | | | 45 | 45 | 45 | 45 |
| (D) Phenoxy resin | Phenoxy resin 1 | | | | 5 | 5 | 5 | 5 |
| Curing catalyst | Curing catalyst 1 | | | | 5 | 5 | 5 | 5 |
| Resin portion total | | | | | 100 | 100 | 100 | 100 |
| (C) Thermally conductive particles | | | | Parts by mass | 260 | 260 | 260 | 260 |
| Thermal conductivity at 200°C (W/m·K) | | | | | 12.4 | 12.5 | 11.7 | 12.3 |
| Resin sheet processing process resistance (Determined) | | | | | ∘ | ∘ | ∘ | × |

As shown in Table 1, Comparative Example 1, which used a liquid epoxy resin which did not include a mesogen skeleton, had low thermal conductivity. In Comparative Example 2, which used a liquid epoxy resin including a mesogen skeleton with a softening point of 96°C, cracks were observed in the resin sheet.

In contrast, in the Example, which used a liquid epoxy resin including a mesogen skeleton with a softening point of 60°C or lower, it was possible to obtain a resin sheet which had high thermal conductivity, in which cracks were not observed, and which had excellent processing process resistance.

This application claims priority based on Japanese Application No. 2020-031440, filed on 27 February 2020, the entire disclosure of which is incorporated herein.

### REFERENCE SIGNS LIST

- 100:: metal base substrate
- 101:: metal substrate
- 102:: insulating layer
- 103:: metal layer

## Claims

1. A thermosetting resin composition comprising:
an epoxy resin (A);
a curing agent (B); and
thermally conductive particles (C),
wherein the epoxy resin (A) includes a mesogen skeleton and has a softening point of 60°C or lower, and
a thermal conductivity λ₂₀₀ of a cured product of the thermosetting resin composition at 200°C is 12.0 W/(m·K) or higher.

2. The thermosetting resin composition according to claim 1,
wherein the thermosetting resin composition includes 100% by mass to 400% by mass of the thermally conductive particles (C) with respect to a resin component (100% by mass) of the thermosetting resin composition.

3. The thermosetting resin composition according to claim 1 or 2,
wherein the thermally conductive particles (C) include at least one selected from alumina, aluminum nitride, boron nitride, silicon nitride, silicon carbide, and magnesium oxide.

4. The thermosetting resin composition according to claim 3,
wherein the thermally conductive particles (C) include the boron nitride, and
the boron nitride includes monodispersed particles, granular particles, or aggregated particles of scaly boron nitride, or a mixture thereof.

5. The thermosetting resin composition according to any one of claims 1 to 4,
wherein the curing agent (B) includes a cyanate resin.

6. The thermosetting resin composition according to any one of claims 1 to 5, further comprising:
a phenoxy resin (D).

7. A resin sheet comprising:
the thermosetting resin composition according to any one of claims 1 to 6.

8. A metal base substrate comprising in the following order:
a metal substrate;
an insulating layer comprised of the resin sheet according to claim 7; and
a metal layer.
